# EUROPÄISCHE PATENTSCHRIFT

(11) **EP 2 281 072 B1**
(45) Veröffentlichungstag und Bekanntmachung des Hinweises auf die Patenterteilung: **16.12.2015**
(21) Anmeldenummer: 09753774.0
(22) Anmeldetag: 05.05.2009
(51) Int. Cl.: C23C 14/08, C23C 28/04

(54) **WERKZEUG MIT METALLOXIDBESCHICHTUNG**
TOOL HAVING A METAL OXIDE COATING
OUTIL DOTÉ D'UN REVÊTEMENT D'OXYDE MÉTALLIQUE

(30) Priorität: 31.05.2008 DE 102008026358
(43) Veröffentlichungstag der Anmeldung: 09.02.2011
(73) Patentinhaber: Walter AG, 72072 Tübingen (DE)
(72) Erfinder: SCHIER, Veit, 70771 Echterdingen (DE); ENGELHART, Wolfgang, 72555 Metzingen (DE)
(74) Vertreter: WSL Patentanwälte Partnerschaft mbB
(86) Internationale Anmeldenummer: PCT/EP2009/055403
(87) Internationale Veröffentlichungsnummer: WO 2009/144119

(56) Entgegenhaltungen:
- WO-A-2006/099754
- WO-A-2008/043606
- JP-A- 2007 111 835
- US-A1- 2006 263 640

## Beschreibung

Die Erfindung betrifft ein Schneidwerkzeug mit einem Grundkörper und einer darauf aufgebrachten mehrlagigen Beschichtung.

### Stand der Technik

Schneidwerkzeuge bestehen aus einem Grundkörper, der beispielsweise aus Hartmetall, Cermet, Stahl oder Schnellarbeitsstahl hergestellt ist. Zur Erhöhung der Standzeiten oder auch zur Verbesserung der Schneideigenschaften wird auf den Grundkörper häufig eine ein- oder mehrlagige Beschichtung aufgebracht. Diese Beschichtung umfasst beispielweise metallische Hartstoffschichten, Oxidschichten und dergleichen. Zum Aufbringen der Beschichtung werden CVD-Verfahren (chemische Gasphasenabscheidung; chemical vapour deposition) und/oder PVD-Verfahren (physikalische Gasphasenabscheidung; physical vapour deposition) angewendet. Mehre Lagen innerhalb einer Beschichtung können ausschließlich mittels CVD-Verfahren, ausschließlich mittels PVD-Verfahren oder durch einer Kombination dieser Verfahren aufgebracht werden.

Bei den PVD-Verfahren unterscheidet man zwischen verschiedenen Verfahrensvarianten, wie Magnetronsputtern, Lichtbogenverdampfen (Arc-PVD), Ionenplattierung, Elektronenstrahlverdampfung und Laserablation. Magnetronsputtern und Lichtbogenverdampfen zählen zu den am häufigsten für die Beschichtung von Werkzeugen angewendeten PVD-Verfahren. Innerhalb einzelner PVD-Verfahrensvarianten gibt es wiederum unterschiedliche Modifikationen, wie beispielweise ungepulstes oder gepulstes Magnetronsputtern oder ungepulstes oder gepulstes Lichtbogenverdampfen usw.

Das Target im PVD-Verfahren kann aus einem reinen Metall oder einer Kombination von zwei oder mehr Metallen bestehen. Umfaßt das Target mehrere Metalle, so werden alle diese Metalle gleichzeitig in die bei dem PVD-Verfahren aufgebaute Lage einer Beschichtung eingebaut. Das Mengenverhältnis der Metalle zueinander in der aufgebauten Lage wird von dem Mengenverhältnis der Metalle in dem Target abhängen, aber auch von den Bedingungen in dem PVD-Verfahren, da einzelne Metalle unter bestimmten Bedingungen in höheren Mengen aus dem Target herausgelöst werden und/oder sich in höheren Mengen auf dem Substrat abscheiden als andere Metalle.

Zur Erzeugung bestimmter Metallverbindungen werden dem Reaktionsraum des PVD-Verfahrens reaktive Gase zugeführt, wie z.B. Stickstoff zur Erzeugung von Nitriden, Sauerstoff zur Erzeugung von Oxiden, kohlenstoffhaltige Verbindungen zur Erzeugung von Carbiden, Carbonitriden, Oxicarbiden etc. oder Gemische dieser Gase zur Erzeugung von entsprechenden Mischverbindungen.

Beim PVD-Verfahren wird an die zu beschichtenden Substrate in der Regel ein sogenanntes Bias-Potential angelegt, um die für den Aufwachsprozess notwendige Oberflächenenergie und damit Atombeweglichkeit zu erreichen. Die Energie ist notwendig, um bei einer aufwachsenden Schicht kristalline Strukturen zu erzielen. Beim Aufbringen von isolierenden Schichten im PVD-Verfahren, was beispielsweise auf eine Vielzahl von Metalloxidverbindungen zutrifft, verringert sich aufgrund der isolierenden Eigenschaften des Schichtmaterials das effektiv angelegte Bias-Potential während des Aufwachsprozesses mit zunehmender Schichtdicke, was die Aufwachsbedingungen an der Schichtoberfläche verschlechtert und im weiteren schließlich zum Aufwachsen von ausschließlich oder hauptsächlich amorphen Strukturen führt. Beim Abscheiden von isolierenden Schichtmaterialien bei Anwendung von Gleichstrom-Bias-Potential (DC-Bias) oder gepulstem Gleichstrom-Bias-Potential sind diese amorphen Strukturen unvermeidlich, aber nicht erwünscht, weil sie schlechtere Materialeigenschaften als kristalline Schichten haben, wie u.a. schlechtere Hochtemperaturbeständigkeit, schlechtere thermodynamische Stabilität, geringere Härte etc.

Ramm, J. et al., Pulse enhanced electron emission (P3e™) arc evaporation and the synthesis of wear resistant Al-Cr-O coatings in corundum structure, Surface & Coatings Technology 202 (2007), S. 876-883, beschreiben die Abscheidung von Aluminiumoxid-Chromoxid-Schichten durch gepulstes Lichtbogenverdampfen (Arc-PVD). Die abgeschiedenen Schichten zeigen zunächst eine Mischkristallstruktur, die mit zunehmender Schichtdicke zur Oberfläche hin amorph wird.

Teixeira, V. et al., Deposition of composite and nanolaminate ceramic coatings by sputtering, Vacuum 67 (2002), S. 477-483, beschreiben das Abscheiden von dünnen Zirconiumoxid/Aluminiumoxid-Schichten im Nanometerbereich durch Magnetronsputtern. Die Schichten zeigen kristalline Anteile von Zirconiumoxid, aber lediglich amorphe Anteile an Aluminiumoxid. Trinh, D. H. et al., Radio frequency dual magnetron sputtering deposition and characterization of nanocomposite Al203 - ZrO2 thin films, J. Vac. Sc. Techn. A 24(2), März/April 2006, S. 309-316 beschreiben das Abscheiden sehr dünner Zirconiumoxid/Aluminiumoxid-Schichten im Nanometerbereich durch Magnetronsputtern, welche kristalline Anteile an Zirconiumoxid zeigen, jedoch keine kristallinen Anteile an Aluminiumoxid.

Die WO 2008/043606 A1 offenbart ein im PVD-Verfahren aufgebrachtes ein-oder mehrlagiges Schichtsystem mit zumindest einer Mischkristallschicht eines Mehrfachoxids, beispielsweise Aluminium-Chrom-Oxid, auf einem Substrat, wobei die Mischkristallschicht eine Korundstruktur aufweist.

Die US 2006/263640 A1 beschreibt ebenfalls eine mehrlagige Beschichtung auf einem Substrat, wobei sich α-Aluminiumoxid-Schichten mit Schichten mit Korundstruktur aus einem Gemisch von Aluminiumoxid und weiterem Metalloxid oder aus Metalloxidschichten, die kein Aluminiumoxid endhalten, abwechseln. Dadurch soll das Kristallwachstum des Aluminiumoxids eingedämmt und das Entstehen zu großer Kristalle zu verhindert werden, damit die Oberflächenrauheit der Aluminiumoxid-Schicht nicht zu hoch wird, da eine große Oberflächenrauheit der äußeren Aluminiumoxid-Schicht auf einem Werkzeug für die Metallbearbeitung durch hohe Reibung und Anhaftung der Oberfläche der Aluminiumoxid-Schicht an dem Werkstück zu verschiedenen Problemen führen kann.

Aus JP-A-2007 111835 ist ein Schneidwerkzeug bekannt, auf dem ein Schichtstapel aus Aluminiumchromoxidlagen und Zirkonoxidlagen im CVD abgeschieden wurde.

### AUFGABE

Die Aufgabe der vorliegenden Erfindung bestand darin, gegenüber dem Stand der Technik verbesserte Schneidwerkzeuge bereitzustellen, insbesondere mit einer mehrlagigen Beschichtung mit Metalloxidlagen mit sehr hohem kristallinem Anteil.

Gelöst wird die erfindungsgemäße Aufgabe durch ein Schneidwerkzeug mit einem Grundkörper und einer darauf aufgebrachten mehrlagigen Beschichtung,
welche, gegebenenfalls neben weiteren Lagen, mehrere abwechselnd direkt übereinander aufgebrachte Hauptlagen A und Zwischenlagen B umfaßt,
wobei die Hauptlagen A und die Zwischenlagen B jeweils im PVD-Verfahren hergestellte Metalloxidlagen sind,
die Dicke der Hauptlagen A im Bereich von 4 nm bis 1 µm liegt und
die Dicke der Zwischenlagen B im Bereich von 2 nm bis 50 nm liegt,
wobei das Verhältnis der Dicken der Zwischenlagen B zu den Dicken der Hauptlagen A im Bereich von 1:2 bis 1:100 liegt und
wobei innerhalb einer Hauptlage A der Anteil an kristallin vorliegendem Metalloxid über die gesamte Dicke der jeweiligen Hauptlage A in Richtung vom Substrat nach Außen von einem Anteil im Bereich von 100 bis 90 Vol.-% kristallinem Metalloxid auf einen Anteil von wenigstens 80 Vol.-% kristallinem Metalloxid abnimmt und
wobei die Hauptlagen A aus AlCr-Mischoxid bestehen und die Zwischenlagen B aus Zr-Oxid, Y-Oxid oder ZrY-Mischoxid bestehen.

Wie einleitend bereits geschildert wurde, besteht bei der Abscheidung vieler Metalloxide im PVD-Verfahren aufgrund ihrer isolierenden Eigenschaften das Problem, dass das angelegte Bias-Potential mit wachsender Schichtdicke abnimmt, womit gleichzeitig auch die Kristallinität der abgeschiedenen Schicht geringer wird und der amorphe Anteil zunimmt. Dies verschlechtert eine Mehrzahl der für eine solche Beschichtung gewünschten Materialeigenschaften. Erfindungsgemäß wird dieses Problem überwunden, indem beim Abscheiden eines Hauptmaterials aus Metalloxid, welches hier die Hauptlagen A bildet, dünne Zwischenlagen B aus einem Zwischenlagenmaterial eingefügt werden. Das Hauptlagenmaterial A würde aufgrund seiner isolierenden Eigenschaften bei der Abscheidung im PVD-Verfahren mit zunehmender Schichtdicke mehr und mehr an Kristallinität verlieren und zunehmend amorphe Struktur ausbilden. Das Zwischenlagenmaterial B ist so ausgewählt, dass es bei den Abscheidungsbedingungen kristallin auf die Hauptlage A aufwächst und damit das erneute kristalline Aufwachsen des Hauptlagenmaterials A fördert.

Die Dicke der Hauptlagen A liegt im Bereich von 4 nm bis 1 µm, und die Dicke der Zwischenlagen B liegt im Bereich von 2 nm bis 50 nm. Das Verhältnis der Dicken der Zwischenlagen B zu den Dicken der Hauptlagen A liegt im Bereich von 1:2 bis 1:100. Die Zwischenlagen B sind also sehr dünn im Verhältnis zu den Hauptlagen A. Es ist nicht erforderlich, dass die Dicken der Einzellagen, d.h. die Dicken der Hauptlagen A untereinander und die Dicken der Zwischenlagen B untereinander, über die gesamte Schicht konstant gehalten werden. Die Hauptlagen A, welche durch Zwischenlagen B voneinander getrennt sind, können unterschiedliche Schichtdicken haben, wie auch die einzelnen Zwischenlagen B unterschiedlich dick sein können. Alternativ können selbstverständlich auch die Hauptlagen A durchgängig gleiche Dicken haben und/oder die Zwischenlagen B durchgängig gleiche Dicken haben. Beispielsweise können abwechselnd 15 nm dicke Hauptlagen A aus Aluminium/Chrom-Oxid sich mit 3 nm dicken Zwischenlagen B aus Zirconiumoxid abwechseln und bis zu einer Gesamtschichtdicke von mehr als 5 µm gleichmäßig kristallin abgeschieden werden.

In einer Ausführungsform der Erfindung bestehen die Hauptlagen A aus (Al,Cr)₂O₃.

Erfindungsgemäß bestehen die Zwischenlagen B aus Zr-Oxid, Y-Oxid oder Zr-Y-Mischoxid. Zwischenlagen B aus Zr-Oxid sind ganz besonders bevorzugt, da sie auch bei geringem Bias noch kristallin aufwachsen.

Eine vollständige Kristallinität der Hauptlagen A läßt sich nicht immer gewährleisten. Auch bei dünnen Hauptlagen A vor der Abscheidung einer neuen Zwischenlage B kann es innerhalb der Hauptlagen zu einer Abnahme des kristallinen und einer Zunahme des amorphen Anteils der abgeschiedenen Verbindung(en) kommen. Die Erfindung umfaßt auch solche Schneidwerkzeuge, jedoch nur soweit der überwiegende Anteil der Hauptlagen A kristallin vorliegt. Vorzugsweise liegen mehr als 80 Vol.-% der Hauptlagen A kristallin vor, besonders bevorzugt liegen mehr als 90 Vol.-% der Hauptlagen A kristallin vor und ganz besonders bevorzugt liegen mehr als 95 Vol.-% der Hauptlagen A kristallin vor.

Bei einer Abnahme des kristallinen und einer Zunahme des amorphen Anteils der abgeschiedenen Metalloxidverbindung(en) entsteht somit ein Gradient mit abnehmender Kristallinität. Vorzugsweise soll dabei bei beginnender Abscheidung einer Hauptlage A, d. h. zum Beispiel direkt im Anschluß an eine Zwischenlage B, das abgeschiedene Metalloxid nahezu vollständig kristallin vorliegen. Mit zunehmender Schichtdicke einer Hauptlage A kann die Kristallinität im Verlaufe der Abscheidung abnehmen, jedoch sollte die Abnahme an Kristallinität nicht unter 80 Vol.-%, vorzugsweise nicht unter 85 Vol.-% kristallinem Metalloxid absinken. Sollte die Kristallinität stärker absinken, so wäre die Schichtdicke geringer zu halten und früher eine Zwischenlage B abzuscheiden.

In einer bevorzugten Ausführungsform umfaßt die Erfindung daher ein Schneidwerkzeug der vorgenannten Art, wobei innerhalb einer Hauptlage A der Anteil an kristallin vorliegendem Metalloxid über die gesamte Dicke der jeweiligen Hauptlage A in Richtung vom Substrat nach Außen von einem Anteil im Bereich von 100 bis 95 Vol.-% kristallinem Metalloxid auf einen Anteil von wenigstens 80 Vol.-% kristallinem Metalloxid, vorzugsweise von wenigstens 85 Vol.-% kristallinem Metalloxid abnimmt.

Der Volumenanteil an kristallinem Metalloxid in den abgeschiedenen Schichten wird mittels Röntgenmessungen bestimmt, vorliegend durch Röntgenmessung in streifendem Einfall (Gracing Incidence X-Ray Diffraction = GIXRD). Dieses Standardverfahren liefert semiquantitative Informationen über die Kristallinität in der Probe, welche mit der Intensität der Röntgenpeaks korreliert. Zudem kann nach diesem Verfahren in bestimmten Meßanordnungen und durch Variation der Strahlungswinkel tiefenabhängige Röntgenstrukturaufklärung durchgeführt werden.

In einer weiteren bevorzugten Ausführungsform der Erfindung liegt die Dicke der Hauptlagen A im Bereich von 5 nm bis 50 nm, vorzugsweise im Bereich von 10 nm bis 30 nm, und/oder die Dicke der Zwischenlagen B liegt im Bereich von 3 nm bis 15 nm, vorzugsweise im Bereich von 3 nm bis 8 nm.

Das durch die Erfindung zu überwindende Problem des Metalloxid-Materials der Hauptlagen A besteht darin, dass das Material bei der PVD-Abscheidung mit zunehmender Schichtdicke an Kristallinität verliert und höhere amorphe Anteile erhält. Wann der amorphe Anteil bei der Abscheidung einer Beschichtung in welchem Maße ansteigt, hängt von verschiedenen Parametern ab, wie beispielsweise dem abgeschiedenen Schichtmaterial selbst und den verschiedenen Bedingungen im PVD-Abscheidungsverfahren. Es lässt sich daher nicht von vorneherein für jedes Material und für jedes Abscheidungsverfahren festlegen, ab welcher Schichtdicke über einer abgeschiedenen Hauptlage A wieder eine Zwischenlage B aufzubringen ist, um die Ausbildung amorpher Strukturen aufzuhalten bzw. zu verhindern und das kristalline Wachstum weiter zu begünstigen. Nicht zuletzt hängt die Auswahl der Dicke der Hauptlagen A auch davon ab, wie weit das Abweichen von einem rein kristallinen Aufwachsen der Hauptlagen A zugelassen werden soll. Bei einem Hauptlagenmaterial, bei dem schon bei geringer Abscheidungsdicke die Veränderung zu amorphen Strukturen einsetzt, wird das Aufbringen einer Zwischenlage B schon bei geringerer Dicke der Hauptlage A erforderlich sein als bei einem Material, das bis zu einer höheren Schichtdicke in der kristallinen Form aufwächst. Die hierfür erforderlichen idealen Bedingungen und Schichtdicken lassen sich jedoch vom Fachmann auf dem Gebiet für bestimmte Materialkombinationen und PVD-Verfahren durch einfache Experimente ermitteln. Als Faustregel gilt, dass das Hauptlagenmaterial über die gesamte Schicht hinweg eine höhere Kristallinität erhält, wenn die einzelnen Hauptlagen A eine geringere Schichtdicke haben, bevor eine Zwischenlage B folgt und damit das erneute kristalline Aufwachsen des Hauptlagenmaterials A darauf fördert. Die Dicke der Hauptlagen A sollte aber auch nicht zu gering gewählt werden, damit der Anteil des Zwischenlagenmaterials B, das ja im wesentlichen dem Erhalt der kristallinen Struktur beim Aufwachsen des Hauptlagenmaterials A dienen soll, nicht zu hoch und nicht bestimmender Bestandteil der Gesamtschicht wird.

Vorzugsweise liegt das Verhältnis der Dicken der Zwischenlagen B zu den Dicken der Hauptlagen A im Bereich von 1:3 bis 1:20, besonders bevorzugt im Bereich von 1:4 bis 1:8.

In einer bevorzugten Ausführungsform der Erfindung bestehen die Hauptlagen A überwiegend aus gemischt kristallinem (Al,Cr)₂O₃ mit Korundstruktur und/oder die Zwischenlagen B überwiegend aus kristallinem ZrO₂. Viele andere Metalloxide bzw. Metalloxidkombinationen als Beschichtungen haben sich als zu weich für die Metallzerspanung erwiesen.

Für die Abscheidung der Beschichtungen des erfindungsgemäßen Schneidwerkzeugs eignen sich alle bekannten PVD-Verfahren. Bevorzugt sind die PVD-Verfahren zur Herstellung der Hauptlagen A und der Zwischenlagen B unter Magnetronsputtern, Lichtbogenverdampfen (Arc-PVD), Ionenplattierung, Elektronenstrahlverdampfung und Laserablation ausgewählt.

Das Schneidwerkzeug der vorliegenden Erfindung weist in einer Ausführungsform eine Beschichtung auf, die nur aus den auf dem Grundkörper abwechselnd direkt übereinander aufgebrachter Hauptlagen A und Zwischenlagen B besteht. Alternativ umfaßt die Beschichtung noch weitere Lagen über und/oder unter der Mehrzahl abwechselnd direkt übereinander aufgebrachter Hauptlagen A und Zwischenlagen B, wobei diese zusätzlichen Lagen in der Beschichtung ausgewählt sind unter Carbiden, Nitriden, Oxiden, Carbonitriden, Oxinitriden, Oxicarbiden, Oxicarbonitriden, Boriden, Boronitriden, Borocarbide, Borocarbonitride, Borooxinitride, Borooxocarbide, Borooxocarbonitride, Oxoboronitriden der Elemente der Gruppen IVa bis VIIa des Periodensystems und/oder des Aluminiums und/oder des Siliziums, einschließlich gemischtmetallischen Phasen sowie Phasengemischen der vorgenannten Verbindungen. Beispiele für geeignete zusätzliche Lagen in der erfindungsgemäßen Beschichtung sind TiAIN-Lagen, TiN-Lagen oder TiC-Lagen.

In einer weiteren Ausführungsform der Erfindung weist die Schicht aus der Mehrzahl abwechselnd direkt übereinander aufgebrachter Hauptlagen A und Zwischenlagen B eine Gesamtdicke von 1 µm bis 20 µm, vorzugsweise von 2 µm bis 15 µm, besonders bevorzugt von 3 µm bis 10 µm, ganz besonders bevorzugt von 4 µm bis 7 µm auf. Bei zu hohen Schichtdicken besteht die Gefahr des Abplatzens aufgrund zu hoher mechanischer Spannungen in der Schicht.

In einer weiteren Ausführungsform der Erfindung weist die Beschichtung eine Vickers-Härte (Hv) von 1000 bis 4000, vorzugsweise von mehr als 1500, besonders bevorzugt von mehr als 2000 auf.

Der Grundkörper des erfindungsgemäßen Schneidwerkzeugs ist zweckmäßigerweise aus Hartmetall, Cermet, Stahl oder Schnellarbeitsstahl (HSS) hergestellt.

In einer weiteren Ausführungsform der Erfindung haben die Metalloxide der abwechselnd direkt übereinander aufgebrachter Hauptlagen A und Zwischenlagen B gleiche Kristallstruktur.

Die neuartige Beschichtung der vorliegenden Erfindung eröffnet ein breites Spektrum an Möglichkeiten zur Verbesserung und/oder Anpassung der Verschleißfestigkeit, der Standzeiten und/oder der Schneideigenschaften von Schneidwerkzeugen, da sich erfindungsgemäß Metalloxidschichten mit kristalliner Struktur abscheiden lassen, die bislang aus den oben genannten Gründen einen hohen amorphen Strukturanteil und daher andere Materialeigenschaften als die Beschichtung der vorliegenden Erfindung hatten.

Die Verschleißbeständigkeit, Standfestigkeit und Schneideigenschaften einer Beschichtung auf einem Schneidwerkzeug hängt von verschiedenen Faktoren ab, wie beispielsweise dem Material des Grundkörpers des Schneidwerkzeugs, der Abfolge, Art und Zusammensetzung der in der Beschichtung vorhandenen Lagen, der Dicke der verschiedenen Lagen und nicht zuletzt der Art der mit dem Schneidwerkzeug durchgeführten Schneidoperation. Für ein und dasselbe Schneidwerkzeug können sich unterschiedliche Verschleißfestigkeiten in Abhängigkeit von der Art des zu bearbeitenden Werkstücks, dem jeweiligen Bearbeitungsverfahren und den weiteren Bedingungen während der Bearbeitung, wie beispielweise Entwicklung hoher Temperaturen oder Verwendung korrosiver Kühlflüssigkeiten, ergeben. Darüber hinaus unterscheidet man zwischen verschiedenen Verschleißarten, die je nach Bearbeitungsvorgang die Nutzungsdauer eines Werkzeugs, d. h. seine Standzeit, stärker oder geringer beeinflussen können. Die Weiterentwicklung und Verbesserung von Schneidwerkzeugen ist daher stets im Hinblick darauf zu betrachten, welche Werkzeugeigenschaften verbessert werden sollen, und unter vergleichbaren Bedingungen gegenüber dem Stand der Technik zu beurteilen.

Eine wesentliche Eigenschaft von Schneidwerkzeugen, die durch die erfindungsgemäße Beschichtung gegenüber dem Stand der Technik mit Beschichtungen aus den gleichen Materialien verbessert wird, ist die Härte einer solchen Beschichtung. Die deutlich höhere Härte der erfindungsgemäßen Beschichtung ist auf den hohen Anteil an Kristallinität zurückzuführen, der bei der erfindungsgemäßen Beschichtung erreicht wird. Mittels PVD-Verfahren aufgebrachte Metalloxidbeschichtungen nach dem Stand der Technik mit vergleichbaren Schichtdicken weisen in der Regel einen deutlich höheren amorphen Anteil der Struktur auf, was die Materialeigenschaften, u.a. die Härte, nachteilig beeinflusst.

Ein weiterer überraschender Effekt, der bei erfindungsgemäßen Beschichtungen beobachtet wurde, ist eine Reduzierung der Wärmeleitfähigkeit der Gesamtbeschichtung. Diese überraschend erreichte Reduzierung der Wärmeleitfähigkeit der Beschichtung wirkt sich sehr positiv im Einsatz solcher Schneidwerkzeuge bei der Zerspanung von Metallen und Verbundmaterialien aus. Die reduzierte Wärmeleitfähigkeit führt zu einer verbesserten Thermoschockbeständigkeit und damit zu erhöhter Kammrissfestigkeit.

Der Grund für die gegenüber Beschichtungen aus dem Stand der Technik reduzierte Wärmeleitfähigkeit bei den erfindungsgemäßen Beschichtungen ist nicht genau geklärt. Es wird vermutet, dass die reduzierte Wärmeleitfähigkeit auf die in die Beschichtung integrierten Zwischenlagen B zurückzuführen sein könnte. Genauere Aufschlüsse über die zur reduzierten Wärmeleitfähigkeit führenden Mechanismen sollen weitere Versuche mit unterschiedlichen Beschichtungsmaterialien liefern, die derzeit in Arbeit sind.

Es versteht sich von selbst, daß sämtliche Einzelmerkmale, wie sie für bestimmte erfindungsgemäße Ausführungsformen hierin beschrieben sind, soweit dies technisch sinnvoll und möglich ist, mit allen übrigen beschriebenen Merkmalen erfindungsgemäßer Ausführungsformen kombinierbar sind und solche Kombinationen als im Rahmen dieser Beschreibung offenbart angesehen werden. Auf die einzelne Benennung sämtlicher möglicher Kombinationen wird hierin lediglich aus Gründen der besseren Lesbarkeit verzichtet.

Weitere Vorteile, Merkmale und Ausführungsformen der vorliegenden Erfindung werden anhand der nachfolgenden Beispiele erläutert.

### BEISPIELE

In einer PVD-Beschichtungsanlage (Flexicoat; Hauzer Techno Coating) wurden Hartmetallsubstrate der Zusammensetzung mit einer mehrlagigen PVD-Beschichtung versehen. Die Substratgeometrie war SEHW120408 bzw. ADMT160608-F56 (nach DIN-ISO 1832). Vor der Abscheidung der Lagen wurde die Anlage auf 1x10⁻⁵ mbar evakuiert und die Hartmetalloberfläche durch Ionenätzen mit 170 V Vorspannung gereinigt.

### Beispiel 1

### Hauptlagen A: (Al,Cr)₂O₃

▪ PVD-Verfahren: Lichtbogenverdampfen (Arc-PVD)
▪ Target: Al/Cr (70/30 At.-%) Rundquelle (63 mm Durchmesser),
▪ Abscheidung: Temperatur: 600°C; Verdampferstrom: 80 Ampere;
   1 Pa O₂-Druck,
   100 Volt Substratvorspannung, DC gepulst mit 70 kHz

### Zwischenlagen B: ZrO₂

▪ PVD-Verfahren: Lichtbogenverdampfen (Arc-PVD)
▪ Target: Zr-Rundquelle (63 mm Durchmesser),
▪ Abscheidung: Temperatur: 600°C; Verdampferstrom: 80 Ampere;
   1 Pa O₂-Druck,
   100 Volt Substratvorspannung, DC gepulst mit 70 kHz
▪ Schichtdicken: Hauptlagen A: 150 nm (Al,Cr)₂O₃
   Zwischenlagen B: 10 nm ZrO₂
   Gesamtschicht aus Hauptlagen A und Zwischenlagen B: ca. 5 µm

### Vergleichsbeispiel 1

Wie Beispiel 1, jedoch ohne Abscheidung von Zwischenlagen B.

Gemäß dem erfindungsgemäßen Beispiel 1 wurden abwechselnd Hauptlagen A in einer Dicke von 150 nm und dazwischen Zwischenlagen B in einer Dicke von 10 nm bis zu einer Gesamtschichtdicke von ca. 5 µm auf dem Substartkörper abgeschieden. Die Untersuchungen zeigten, dass die gesamte Beschichtung in allen Lagen über die vollständige Schichtdicke gleichmäßig hohe Kristallinität über 95 Vol.-% aufwies.

In einem Vergleichsversuch (Vergleichsbeispiel 1) wurde nur Hauptlagenmaterial A (Al,Cr)₂O₃ ohne Zwischenlagen nach dem gleichem Verfahren wie in Beispiel 1 abgeschieden. Die Beschichtung wächst zunächst kristallin in einem Mischkristall in Korund-Struktur auf. Ab einer Schichtdicke von etwa 2 µm wird die Schicht zunehmend amorph und ist nach ca. 4 µm röntgenamorph und bleibt im weiteren strukturlos.

Die gemessene Vickers-Härte der in Beispiel 1 erfindungsgemäß aufgebrachten kristallinen Schicht betrug ca. 2.000 Hv, wogegen die im Vergleichsbeispiel 1 aufgebrachte Schicht mit hohem amorphem Anteil lediglich eine Härte von ca. 1.000 Hv aufwies.

Darüber hinaus zeigte die erfindungsgemäß gemäß Beispiel 1 aufgebrachte Schicht eine deutlich geringere Wärmeleitfähigkeit als die nach dem Vergleichsbeispiel 1 abgeschiedene Schicht ohne Zwischenlagen B.

In einem Fräsversuch an einem Werkstück aus 42CrMoV4-Stahl (Festigkeit: 850 MPa) wurden die Schneidwerkzeuge aus Beispiel 1 und Vergleichsbeispiel 1 verglichen. Für diese Versuche wurden die Substrate zunächst mit einer 3 µm dicken Beschichtung aus TiAlN versehen, bevor die oxidischen Haupt- und Zwischenlagenmaterialien aufgebracht wurden. Es wurde im Gleichlauf ohne Kühlschmierstoff mit einer Schnittgeschwindigkeit v_{c} = 236 m/min und einem Zahnvorschub f_{z} = 0,2 mm gefräst.

Der Verschleiß wurde auf der Freifläche als mittlere Verschleißmarkenbreite VB in mm (an der Hauptschneide) nach einem Fräsweg von 4800 mm gemessen. Es wurden folgende Verschleißmarkenbreiten VB festgestellt:
Verschleißmarkenbreite VB

| | |
|---|---|
| **Beispiel 1:** | 0,12 mm |
| **Vergleichsbeispiel 1:** | 0,20 mm |

## Patentansprüche

1. Schneidwerkzeug mit einem Grundkörper und einer darauf aufgebrachten mehrlagigen Beschichtung,
welche, gegebenenfalls neben weiteren Lagen, mehrere abwechselnd direkt übereinander aufgebrachte Hauptlagen A und Zwischenlagen B umfaßt,
wobei die Hauptlagen A und die Zwischenlagen B jeweils im PVD-Verfahren hergestellte Metalloxidlagen sind,
die Dicke der Hauptlagen A im Bereich von 4 nm bis 1 µm liegt und
die Dicke der Zwischenlagen B im Bereich von 2 nm bis 50 nm liegt,
wobei das Verhältnis der Dicken der Zwischenlagen B zu den Dicken der Hauptlagen A im Bereich von 1:2 bis 1:100 liegt und
wobei innerhalb einer Hauptlage A der Anteil an kristallin vorliegendem Metalloxid über die gesamte Dicke der jeweiligen Hauptlage A in Richtung vom Substrat nach Außen von einem Anteil im Bereich von 100 bis 90 Vol.-% kristallinem Metalloxid auf einen Anteil von wenigstens 80 Vol.-% kristallinem Metalloxid abnimmt und
wobei die Hauptlagen A aus AlCr-Mischoxid bestehen und die Zwischenlagen B aus Zr-Oxid, Y-Oxid oder ZrY-Mischoxid bestehen.

2. Schneidwerkzeug nach Anspruch 1, **dadurch gekennzeichnet, daß** die Hauptlagen A aus (Al,Cr)₂O₃ bestehen.

3. Schneidwerkzeug nach einem der vorangegangenen Ansprüche, **dadurch gekennzeichnet, daß** der überwiegende Anteil der Hauptlagen A kristallin vorliegt, vorzugsweise mehr als 80 Vol.-% der Hauptlagen A kristallin vorliegen, besonders bevorzugt mehr als 90 Vol.-% der Hauptlagen A kristallin vorliegen und ganz besonders bevorzugt mehr als 95 Vol.-% der Hauptlagen A kristallin vorliegen.

4. Schneidwerkzeug nach einem der vorangegangenen Ansprüche, **dadurch gekennzeichnet, daß** innerhalb einer Hauptlage A der Anteil an kristallin vorliegendem Metalloxid über die gesamte Dicke der jeweiligen Hauptlage A in Richtung vom Substrat nach Außen von einem Anteil im Bereich von 100 bis 95 Vol.-% kristallinem Metalloxidkristallinem Metalloxid auf einen Anteil von wenigstens 80 Vol.-% kristallinem Metalloxid, vorzugsweise von wenigstens 85 Vol.-% kristallinem Metalloxid abnimmt.

5. Schneidwerkzeug nach einem der vorangegangenen Ansprüche, **dadurch gekennzeichnet, daß** die Dicke der Hauptlagen A im Bereich von 5 nm bis 50 nm liegt, vorzugsweise im Bereich von 10 nm bis 30 nm, und/oder die Dicke der Zwischenlagen B im Bereich von 3 nm bis 15 nm liegt, vorzugsweise im Bereich von 3 nm bis 8 nm.

6. Schneidwerkzeug nach einem der vorangegangenen Ansprüche, **dadurch gekennzeichnet, daß** das Verhältnis der Dicken der Zwischenlagen B zu den Dicken der Hauptlagen A im Bereich von 1:3 bis 1:20 liegt, vorzugsweise im Bereich von 1:4 bis 1:8.

7. Schneidwerkzeug nach einem der vorangegangenen Ansprüche, **dadurch gekennzeichnet, daß** die Hauptlagen A überwiegend aus gemischt kristallinem (Al,Cr)₂O₃ mit Korundstruktur bestehen und/oder die Zwischenlagen B überwiegend aus kristallinem ZrO₂ bestehen.

8. Schneidwerkzeug nach einem der vorangegangenen Ansprüche, **dadurch gekennzeichnet, daß** die PVD-Verfahren zur Herstellung der Hauptlagen A und der Zwischenlagen B ausgewählt sind unter i) rMS, ii) Lichtbogenverdampfen (Arc-PVD), iii) Ionenplattierung, iv) Elektronenstrahlverdampfung und v) Laserablation.

9. Schneidwerkzeug nach einem der vorangegangenen Ansprüche, **dadurch gekennzeichnet, daß** die Beschichtung neben der Mehrzahl abwechselnd direkt übereinander aufgebrachter Hauptlagen A und Zwischenlagen B weitere Lagen umfaßt, ausgewählt unter Carbiden, Nitriden, Oxiden, Carbonitriden, Oxinitriden, Oxicarbiden, Oxicarbonitriden, Boriden, Boronitriden, Borocarbide, Borocarbonitride, Borooxinitride, Borooxocarbide, Borooxocarbonitride, Oxoboronitriden der Elemente der Gruppen IVa bis VIIa des Periodensystems und/oder des Aluminiums und/oder des Siliziums, einschließlich gemischtmetallischen Phasen sowie Phasengemischen der vorgenannten Verbindungen.

10. Schneidwerkzeug nach einem der vorangegangenen Ansprüche, **dadurch gekennzeichnet, daß** in der Beschichtung die Mehrzahl abwechselnd direkt übereinander aufgebrachter Hauptlagen A und Zwischenlagen B eine Gesamtdicke von 1 µm bis 20 µm, vorzugsweise von 2 µm bis 15 µm, besonders bevorzugt von 3 µm bis 10 µm, ganz besonders bevorzugt von 4 µm bis 7 µm aufweisen.

11. Schneidwerkzeug nach einem der vorangegangenen Ansprüche, **dadurch gekennzeichnet, daß** die Beschichtung eine Vickers-Härte (Hv) von 1000 bis 4000, vorzugsweise von mehr als 1500, besonders bevorzugt von mehr als 2000 aufweist.

12. Schneidwerkzeug nach einem der vorangegangenen Ansprüche, **dadurch gekennzeichnet, daß** der Grundkörper aus Hartmetall, Cermet, Stahl oder Schnellarbeitsstahl (HSS) hergestellt ist.

13. Schneidwerkzeug nach einem der vorangegangenen Ansprüche, **dadurch gekennzeichnet, daß** die Metalloxide der abwechselnd direkt übereinander aufgebrachter Hauptlagen A und Zwischenlagen B gleiche Kristallstruktur haben.

## Claims

1. A cutting tool comprising a base body and a multi-layer coating applied thereto,
which, possibly besides further layers, includes a plurality of main layers A and intermediate layers B applied alternately directly one upon the other,
wherein the main layers A and the intermediate layers B are respectively metal oxide layers produced by the PVD process,
the thickness of the main layers A is in the range of 4 nm to 1 µm, and
the thickness of the intermediate layers B is in the range of 2 nm to 50 nm,
wherein the ratio of the thicknesses of the intermediate layers B to the thicknesses of the main layers A is in the range of 1:2 to 1:100, and
wherein within a main layer A the proportion of metal oxide in crystalline form decreases over the total thickness of the respective main layer A in the direction from the substrate outwardly from a proportion in the range of 100 to 90 % by volume of crystalline metal oxide to a proportion of at least 80 % by volume of crystalline metal oxide, and
wherein the main layers A consist of AlCr mixed oxide and the intermediate layers B consist of Zr oxide, Y oxide or ZrY mixed oxide.

2. A cutting tool according to claim 1 **characterised in that** the main layers A consist of (Al,Cr)₂O₃.

3. A cutting tool according to one of the preceding claims **characterised in that** the predominant proportion of the main layers A is crystalline, preferably more than 80 % by volume of the main layers A is crystalline, particularly preferably more than 90 % by volume of the main layers A is crystalline and quite particularly preferably more than 95 % by volume of the main layers A is crystalline.

4. A cutting tool according to one of the preceding claims **characterised in that** within a main layer A the proportion of metal oxide in crystalline form decreases over the total thickness of the respective main layer A in the direction from the substrate outwardly from a proportion in the range of 100 to 95 % by volume of crystalline metal oxide to a proportion of at least 80 % by volume of crystalline metal oxide, preferably at least 85 % by volume of crystalline metal oxide.

5. A cutting tool according to one of the preceding claims **characterised in that** the thickness of the main layers A is in the range of 5 nm to 50 nm, preferably in the range of 10 nm to 30 nm, and/or the thickness of the intermediate layers B is in the range of 3 nm to 15 nm, preferably in the range of 3 nm to 8 nm.

6. A cutting tool according to one of the preceding claims **characterised in that** the ratio of the thicknesses of the intermediate layers B to the thicknesses of the main layers A is in the range of 1:3 to 1:20, preferably in the range of 1:4 to 1:8.

7. A cutting tool according to one of the preceding claims **characterised in that** the main layers A predominantly consist of mixed-crystalline (Al,Cr)₂O₃ with a corundum structure and/or the intermediate layers B predominantly consist of crystalline ZrO₂.

8. A cutting tool according to one of the preceding claims **characterised in that** the PVD processes for the production of the main layers A and the intermediate layers B are selected from i) rMS, ii) arc vapour deposition (arc-PVD), iii) ion plating, iv) electron beam vapour deposition, and v) laser ablation.

9. A cutting tool according to one of the preceding claims **characterised in that** besides the multiplicity of main layers A and intermediate layers B which are alternately applied in directly mutually superposed relationship the coating includes further layers selected from carbides, nitrides, oxides, carbonitrides, oxynitrides, oxycarbides, oxycarbonitrides, borides, boron nitrides, boron carbides, boron carbonitrides, boron oxynitrides, boron oxocarbides, boron oxocarbonitrides, oxoboron nitrides of the elements of groups IVa to VIIa of the periodic system and/or aluminium and/or silicon including mixed-metallic phases as well as phase mixtures of the aforementioned compounds.

10. A cutting tool according to one of the preceding claims **characterised in that** in the coating the multiplicity of main layers A and intermediate layers B which are alternately applied in directly mutually superposed relationship are of a total thickness of 1 µm to 20 µm, preferably 2 µm to 15 µm, particularly preferably 3 µm to 10 µm, quite particularly preferably 4 µm to 7 µm.

11. A cutting tool according to one of the preceding claims **characterised in that** the coating has a Vickers hardness (Hv) of 1000 to 4000, preferably more than 1500, particularly preferably more than 2000.

12. A cutting tool according to one of the preceding claims **characterised in that** the base body is made of carbide metal, cermet, steel or high-speed steel (HSS).

13. A cutting tool according to one of the preceding claims **characterised in that** the metal oxides of the main layers A and intermediate layers B which are alternately applied in directly mutually superposed relationship have the same crystal structure.

## Revendications

1. Outil de découpe comprenant un corps de base pourvu d'un revêtement multicouche qui comprend, éventuellement en plus d'autres couches, plusieurs couches principales A et des couches intermédiaires B appliquées en alternance directement les unes sur les autres,
les couches principales A et les couches intermédiaires B étant chacune des couches d'oxyde métallique fabriquées par le procédé de dépôt physique en phase vapeur,
l'épaisseur des couches principales A se situant dans la plage allant de 4 nm à 1 µm, et
l'épaisseur des couches intermédiaires B se situant dans la plage allant de 2 nm à 50 nm,
le rapport entre les épaisseurs des couches intermédiaires B et les épaisseurs des couches principales A se situant dans la plage allant de 1:2 à 1:100, et
à l'intérieur d'une couche principale A, la proportion d'oxyde métallique présent sous forme cristalline sur l'épaisseur totale de la couche principale A en question diminuant dans la direction allant du substrat vers l'extérieur d'une proportion dans la plage allant de 100 à 90 % en volume d'oxyde métallique cristallin à une proportion d'au moins 80 % en volume d'oxyde métallique cristallin, et
les couches principales A étant constituées d'un oxyde mixte d'AlCr et les couches intermédiaires B étant constituées d'un oxyde de Zr, d'un oxyde d'Y ou d'un oxyde mixte de ZrY.

2. Outil de découpe selon la revendication 1, **caractérisé en ce que** les couches principales A sont constituées par (Al,Cr)₂O₃.

3. Outil de découpe selon l'une quelconque des revendications précédentes, **caractérisé en ce que** la proportion majoritaire des couches principales A se présente sous forme cristalline, de préférence plus de 80 % en volume des couches principales A se présente sous forme cristalline, de préférence plus de 90 % en volume des couches principales A se présente sous forme cristalline et, de manière plus particulièrement préférée, plus de 95 % en volume des couches principales A se présente sous forme cristalline.

4. Outil de découpe selon l'une quelconque des revendications précédentes, **caractérisé en ce que**, à l'intérieur d'une couche principale A, la proportion d'oxyde métallique présent sous forme cristalline sur l'épaisseur totale de la couche principale A en question diminue dans la direction allant du substrat vers l'extérieur d'une proportion dans la plage allant de 100 à 95 % en volume d'oxyde métallique cristallin à une proportion d'au moins 80 % en volume d'oxyde métallique cristallin, de préférence d'au moins 85 % en volume d'oxyde métallique cristallin.

5. Outil de découpe selon l'une quelconque des revendications précédentes, **caractérisé en ce que** l'épaisseur des couches principales A se situe dans la plage allant de 5 nm à 50 nm, de préférence dans la plage allant de 10 nm à 30 nm, et/ou l'épaisseur des couches intermédiaires B se situe dans la plage allant de 3 nm à 15 nm, de préférence dans la plage allant de 3 nm à 8 nm.

6. Outil de découpe selon l'une quelconque des revendications précédentes, **caractérisé en ce que** le rapport entre les épaisseurs des couches intermédiaires B et les épaisseurs des couches principales A se situe dans la plage allant de 1:3 à 1:20, de préférence dans la plage allant de 1:4 à 1:8.

7. Outil de découpe selon l'une quelconque des revendications précédentes, **caractérisé en ce que** les couches principales A sont principalement constituées par du (Al,Cr)₂O₃ cristallin mixte de structure corindon et/ou les couches intermédiaires B sont principalement constituées par du ZrO₂ cristallin.

8. Outil de découpe selon l'une quelconque des revendications précédentes, **caractérisé en ce que** les procédés de dépôt physique en phase vapeur pour la fabrication des couches principales A et des couches intermédiaires B sont choisis parmi i) la rMS, ii) l'évaporation à arc électrique (Arc-PVD), iii) le placage ionique, iv) l'évaporation à faisceau d'électrons et v) l'ablation laser.

9. Outil de découpe selon l'une quelconque des revendications précédentes, **caractérisé en ce que** le revêtement comprend d'autres couches, en plus de la pluralité de couches principales A et de couches intermédiaires B appliquées en alternance directement les unes sur les autres, choisies parmi les carbures, les nitrures, les oxydes, les carbonitrures, les oxynitrures, les oxycarbures, les oxycarbonitrures, les borures, les boronitrures, les borocarbures, les borocarbonitrures, les borooxynitrures, les borooxocarbures, les borooxocarbonitrures, les oxoboronitrures des éléments des groupes IVa à VIIa du tableau périodique et/ou d'aluminium et/ou de silicium, y compris les phases métalliques mixtes, ainsi que les mélanges de phases des composés susmentionnés.

10. Outil de découpe selon l'une quelconque des revendications précédentes, **caractérisé en ce que**, dans le revêtement, la pluralité de couches principales A et de couches intermédiaires B appliquées en alternance directement les unes sur les autres présente une épaisseur totale de 1 µm à 20 µm, de préférence de 2 µm à 15 µm, de manière particulièrement préférée de 3 µm à 10 µm et, de manière plus particulièrement préférée de 4 µm à 7 µm.

11. Outil de découpe selon l'une quelconque des revendications précédentes, **caractérisé en ce que** le revêtement présente une dureté de Vickers (Hv) de 1 000 à 4 000, de préférence de plus de 1 500 et de manière particulièrement préférée de plus de 2 000.

12. Outil de découpe selon l'une quelconque des revendications précédentes, **caractérisé en ce que** le corps de base est fabriqué en un métal dur, en cermet, en acier ou en un acier à coupe rapide (HSS).

13. Outil de découpe selon l'une quelconque des revendications précédentes, **caractérisé en ce que** les oxydes métalliques des couches principales A et des couches intermédiaires B appliquées en alternance directement les unes sur les autres ont la même structure cristalline.
